# EUROPEAN PATENT APPLICATION

(11) **EP 4 746 247 A1**
(43) Date of publication of application: **20.05.2026**
(21) Application number: 24839932.1
(22) Date of filing: 20.06.2024
(51) Int. Cl.: H02J 50/10, H01F 27/28, H01F 27/08, B60L 53/12, H05K 7/20

(54) **WIRELESS CHARGING PAD AND WIRELESS CHARGING SYSTEM COMPRISING AIR-COOLED HEAT DISSIPATION STRUCTURE**

(30) Priority: 11.07.2023 KR 20230089932
(71) Applicant: Hyundai Motor Company, Seoul 06797 (KR); Kia Corporation, Seoul 06797 (KR); Myongji University Industry and Academia Cooperation Foundation, Gyeonggi-do 54538 (KR)
(72) Inventor: CHI, Soung Hwan, Hwaseong-si, Gyeonggi-do 18280 (KR); SEONG, Jae Yong, Hwaseong-si, Gyeonggi-do 18280 (KR); LEE, Il Oun, Yongin-si, Gyeonggi-do 16822 (KR); BAE, Se Young, Yongin-si, Gyeonggi-do 17058 (KR); JO, Dal Hyeon, Pyeongtaek-si, Gyeonggi-do 18007 (KR)
(74) Representative: Viering, Jentschura & Partner mbB Patent- und Rechtsanwälte
(86) International application number: PCT/KR2024/008542
(87) International publication number: WO 2025/014117

(57) **Abstract**

Disclosed is a wireless charging pad comprising a winding frame, and a coil wound a plurality of times according to a plurality of guides formed on the winding frame, wherein a flow groove extending to two sides from a central portion of the winding frame is formed on the winding frame on the side at which the guides are formed.

## Description

### [Technical Field]

The present disclosure relates to a wireless charging pad and a wireless charging system including an air-cooling heat dissipation structure, and more particularly, to a heat dissipation structure capable of effectively releasing heat generated from a winding of a wireless charging pad in a wireless charging system for an electric vehicle.

### [Background Art]

An electric vehicle (EV) is driven by an electric motor using power stored in a battery, and has the advantages of producing less pollution such as exhaust gas and noise compared with a conventional gasoline engine vehicle, experiencing fewer faults, having a longer life span, and enabling simplified driving operations.

The EVs may be classified into hybrid electric vehicles (HEVs), plug-in hybrid electric vehicles (PHEVs), and electric vehicles (EVs) based on a driving power source. The HEV has an engine as a main power source and a motor as an auxiliary power source. The PHEV has a motor and a battery as a main power source and an engine that is used when the battery is discharged. The EV has a motor but does not have an engine.

An electric vehicle charging system may be defined as a system that charges the battery mounted in the electric vehicle using electric power obtained from a commercial power grid or stored in an energy storage device. Such an electric vehicle charging system may have various forms depending on a type of the electric vehicle. For example, the electric vehicle charging system may include a conductive charging system using a cable or a non-contact wireless power transfer system.

During a charging session, a reception pad of a vehicle assembly (VA) mounted on the electric vehicle may form an inductive resonance coupling with a transmission pad of a ground assembly (GA) installed at a charging station or a charging spot and may charge the battery of the EV using electric power transferred from the ground assembly through the inductive resonance coupling.

In a wireless power transfer system using a magnetic induction method, structures of a transmission pad and a reception pad are important factors for securing power transfer efficiency. More particularly, ferrite, which is a magnetic material that helps wireless power transfer, is embedded in the transmission pad and the reception pad, and a coil surrounding a ferrite structure may be formed. The transmission pad and the reception pad may include a winding frame that maintains structures of the transmission pad and the reception pad by fixing the coil.

According to a structure of a conventional winding frame, the coil and the winding frame are in close contact with each other, and the coil is sealed within the winding frame. Such a structure cannot effectively dissipate heat generated from the coil, and therefore heat is accumulated throughout a wireless charging system including the transmission pad and the reception pad, resulting in reduced stability and decreased wireless charging efficiency during wireless charging.

### [Disclosure]

### [Technical Problem]

In the structure of transmission and reception pads for wireless charging of an electric vehicle in a related art, the winding and the winding frame are in close contact and sealed, making heat dissipation difficult. In addition, in the structure of the related art, heat generated from the winding cannot be effectively discharged, and thus heat is accumulated throughout an entire system, resulting in reduced stability and decreased efficiency.

The present disclosure has been proposed to overcome such problems of the related art.

One of the objectives of the present disclosure is to optimize a heat conduction path by changing a structure of a winding frame, and to efficiently dissipate heat generated from a winding by using forced air cooling and/or natural air cooling, thereby improving stability of an entire system and increasing efficiency.

Another objective of the present disclosure is to provide a wireless charging pad and a wireless charging system including an air-cooling heat dissipation structure.

### [Technical Solution]

According to an aspect of an exemplary embodiment, a wireless charging pad applied as one or more of a reception pad on an electric mobility side or a transmission pad on an electric vehicle supply equipment (EVSE) side to wirelessly transfer electric power from an electric vehicle supply equipment to an electric mobility may be provided. The wireless charging pad includes a winding frame; and a coil disposed in the winding frame to surround a central space. The winding frame may have a flow groove formed therein so that air introduced from a first side surface of the winding frame is discharged toward a second side surface of the winding frame.

The winding frame may have an air flow path formed therein so that air introduced from the first side surface is discharged toward an inlet and outlet portion of the coil.

The flow groove may be formed under the coil.

A plurality of guides may be formed on the winding frame to guide a winding position of the coil.

Air introduced from the first side surface via a fan may pass through a passage formed by segments of the coil wound along the guides and may be discharged toward the second side surface or the inlet and outlet portion.

A point of a first guide of the plurality of guides may contact a point of a first segment of the wound coil, and another point of the first guide of the plurality of guides may contact a point of a second segment of the wound coil.

The wireless charging pad may further include a ferrite core disposed above the coil, and an aluminum plate disposed above the ferrite core.

A part of the coil and a part of the ferrite core may be exposed to the outside by the flow groove.

The wireless charging pad may further include a first insulating pad disposed between the coil and the ferrite core, and a second insulating pad disposed between the ferrite core and the aluminum plate.

According to an aspect of an exemplary embodiment, a wireless charging system for wirelessly transferring electric power from an electric vehicle supply equipment (EVSE) to an electric mobility may be provided. The wireless charging system include a transmission pad on an electric vehicle supply equipment side; and a reception pad on an electric mobility side for receiving wireless power from the transmission pad. Each of the transmission pad and the reception pad includes a winding frame and a coil disposed in the winding frame to surround a central space. The winding frame may have a flow groove formed therein so that air introduced from a first side surface of the winding frame is discharged toward a second side surface of the winding frame.

Air flow path may be formed so that air introduced from the first side surface is discharged toward an inlet and outlet portion of the coil.

The flow groove may be formed under the coil.

A plurality of guides may be formed on the winding frame to guide a winding position of the coil.

Air introduced from the first side surface via a fan may pass through a passage formed by segments of the coil wound along the guides and may be discharged toward the second side surface or the inlet and outlet portion.

A point of a first guide of the plurality of guides may contact a point of a first segment of the wound coil, and another point of the first guide of the plurality of guides may contact a point of a second segment of the wound coil.

The wireless charging system may further include a ferrite core disposed above the wound coil, and an aluminum plate disposed above the ferrite core.

A part of the coil and a part of the ferrite core may be exposed to the outside by the flow groove.

The wireless charging system may further include a first insulating pad disposed between the coil and the ferrite core, and a second insulating pad disposed between the ferrite core and the aluminum plate.

Based on the transmission pad and the reception pad being arranged in parallel, air introduced into the transmission pad and air introduced into the reception pad may be introduced from the same direction.

### [Advantageous Effects]

According to an exemplary embodiment of the present disclosure, a wireless charging pad and a wireless charging system including an air-cooling heat dissipation structure can be provided.

According to an exemplary embodiment of the present disclosure, stability and efficiency during charging of an electric vehicle can be improved by enhancing a heat management method of a wireless charging system for the electric vehicle.

According to an exemplary embodiment of the present disclosure, reliability of a wireless charging system for an electric vehicle can be improved.

### [Description of Drawings]

FIG. 1 is an illustration of a wireless power transfer system to which an exemplary embodiment of the present disclosure is applicable.
FIGS. 2 and 3 illustrate a Cartesian coordinate system compatible with a definition in SAE J2954 standard and applicable to an embodiment of the present disclosure.
FIG. 4 is a circuit diagram of an equivalent circuit of an electric vehicle wireless charging circuit according to an exemplary embodiment of the present disclosure.
FIG. 5 shows an equivalent circuit of a single-phase to single-phase wireless power transfer (WPT) system according to an exemplary embodiment of the present disclosure.
FIG. 6 is a conceptual cross sectional view and an elevation view of a transmission pad 21 according to an exemplary embodiment of the present disclosure.
FIG. 7 is a perspective view illustrating a transmission pad according to a related art exemplary embodiment.
FIG. 8 is a diagram schematically illustrating a structure of a winding frame of a transmission pad according to a related art exemplary embodiment.
FIG. 9 is a perspective view illustrating a reception pad according to a related art exemplary embodiment.
FIG. 10 is a diagram schematically illustrating a structure of a winding frame of a reception pad according to a related art exemplary embodiment.
FIG. 11 is a perspective view illustrating transmission and reception pads according to an exemplary embodiment of the present disclosure.
FIG. 12 is a perspective view illustrating a transmission pad according to an exemplary embodiment of the present disclosure.
FIG. 13 is a perspective view illustrating a reception pad according to an exemplary embodiment of the present disclosure.
FIG. 14 is an exploded cross-sectional view illustrating the transmission pad and the reception pad illustrated in FIG. 11.
FIG. 15 is a view illustrating a side of the transmission pad and the reception pad of FIG. 11, in which inlet and outlet grooves are formed.
FIG. 16 is a view illustrating sides of the transmission pad and the reception pad of FIG. 11, in which flow grooves are formed.
FIG. 17 is a view illustrating the transmission pad and the reception pad of FIG. 16 as viewed from opposite sides.
FIG. 18 is a view illustrating a winding frame of a transmission pad according to an exemplary embodiment of the present disclosure.
FIG. 19 is a view illustrating a transmission pad in which a coil is wound according to an exemplary embodiment of the present disclosure.
FIG. 20 is a view illustrating a transmission pad and a fan according to an exemplary embodiment of the present disclosure.
FIG. 21 is a view for describing an inner winding frame of a reception pad according to an exemplary embodiment of the present disclosure.
FIG. 22 is a view illustrating a reception pad in which a coil is wound according to an exemplary embodiment of the present disclosure.
FIG. 23 is a view illustrating a reception pad and a fan according to an exemplary embodiment of the present disclosure.
FIG. 24 is a block diagram illustrating a generalized configuration of hardware included in or associated with a transmission pad and/or a reception pad of the present disclosure to control a sequence for wireless power transfer.

### [Best mode of the Invention]

For a clearer understanding of the features and advantages of the present disclosure, exemplary embodiments of the present disclosure will be described in detail with reference to the accompanying drawings. However, it should be understood that the present disclosure is not limited to particular embodiments disclosed herein but includes all modifications, equivalents, and alternatives falling within the spirit and scope of the present disclosure.

The terminologies including ordinals such as "first" and "second" designated for explaining various components in this specification are used to discriminate a component from the other ones but are not intended to be limiting to a specific component. For example, a second component may be referred to as a first component and, similarly, a first component may also be referred to as a second component without departing from the scope of the present disclosure. As used herein, the term "and/or" may include a presence of one or more of the associated listed items and any and all combinations of the listed items.

In the description of exemplary embodiments of the present disclosure, "at least one of A and B" may mean "at least one of A or B" or "at least one of combinations of one or more of A and B". In addition, in the description of exemplary embodiments of the present disclosure, "one or more of A and B" may mean "one or more of A or B" or "one or more of combinations of one or more of A and B".

When a component is referred to as being "connected" or "coupled" to another component, the component may be directly connected or coupled logically or physically to the other component or indirectly through an object therebetween. Contrarily, when a component is referred to as being "directly connected" or "directly coupled" to another component, it is to be understood that there is no intervening object between the components. Other words used to describe the relationship between elements should be interpreted in a similar fashion.

The terminologies are used herein for the purpose of describing particular exemplary embodiments only and are not intended to limit the present disclosure. The singular forms include plural referents as well unless the context clearly dictates otherwise. Also, the expressions "comprises," "includes," "constructed," "configured" are used to refer a presence of a combination of stated features, numbers, processing steps, operations, elements, or components, but are not intended to preclude a presence or addition of another feature, number, processing step, operation, element, or component.

Unless defined otherwise, all terms used herein, including technical or scientific terms, have the same meaning as commonly understood by those of ordinary skill in the art to which the present disclosure pertains. Terms such as those defined in a commonly used dictionary should be interpreted as having meanings consistent with their meanings in the context of related literatures and will not be interpreted as having ideal or excessively formal meanings unless explicitly defined in the present application.

Meanwhile, one or more conventional components may be included in a configuration of the present disclosure if necessary, and such components will be described herein to an extent that it does not obscure the technical idea and concept of the present disclosure. If the description of the conventional components may obscure the technical idea and concept of the present disclosure, however, detailed description of such components may be omitted for simplicity.

Terms used in the present disclosure are defined as follows.

"Electric Vehicle (EV)": An automobile, as defined in 49 CFR 523.3, intended for highway use, powered by an electric motor that draws current from an on-vehicle energy storage device, such as a battery, which is rechargeable from an off-vehicle source, such as residential or public electric service or an on-vehicle fuel powered generator.

The EV may include an electric vehicle, an electric automobile, an electric road vehicle (ERV), a plug-in vehicle (PV), an electromotive vehicle (xEV), etc., and the xEV may be classified into a plug-in all-electric vehicle (BEV), a battery electric vehicle, a plug-in electric vehicle (PEV), a hybrid electric vehicle (HEV), a hybrid plug-in electric vehicle (HPEV), a plug-in hybrid electric vehicle (PHEV), etc.

"Plug-in Electric Vehicle (PEV)": An Electric Vehicle that recharges the on-vehicle primary battery by connecting to the power grid.

"Plug-in vehicle (PV)": An electric vehicle rechargeable via wireless charging from an electric vehicle supply equipment (EVSE) without using a physical plug or a physical socket.

"Heavy duty vehicle (H.D. Vehicle)": Any four-or more wheeled vehicle as defined in 49 CFR 523.6 or 49 CFR 37.3 (bus).

"Light duty plug-in electric vehicle": A three or four-wheeled vehicle propelled by an electric motor drawing current from a rechargeable storage battery or other energy devices for use primarily on public streets, roads and highways and rated at less than 4,545 kg gross vehicle weight.

"Wireless power charging system (WCS)": A system for wireless power transfer and control of interactions including operations for an alignment and communications between a supply device (or ground assembly) and an EV device (or vehicle assembly).

"Wireless power transfer (WPT)": A transfer of electric power between a power source such as a utility, the power grid, an energy storage device, a fuel cell generator and the EV through a contactless channel such as electromagnetic induction and resonance.

"Utility": A set of systems which supply electrical energy and include a customer information system (CIS), an advanced metering infrastructure (AMI), rates and revenue system, etc. The utility may provide an EV with energy through rates table and discrete events. Also, the utility may provide information related to certification on EVs, interval of power consumption measurements, and tariff.

"Smart charging": A system in which EVSE and/or EV (including the PEV, or PHEV) communicate with power grid to optimize charging ratio or discharging ratio of EV by reflecting capacity of the power grid or expense of use.

"Automatic charging": A procedure in which inductive charging is automatically performed after a vehicle is located in a proper position corresponding to a primary charger assembly which may transfer power by a conductive or inductive charging. The automatic charging may be performed after obtaining necessary authentication and right.

"Interoperability": A state in which components of a system interwork with corresponding components of the system to perform operations aimed by the system. Additionally, information interoperability may refer to capability that two or more networks, systems, devices, applications, or components may efficiently share and easily use information without causing inconvenience to users.

"Inductive charging system": A system transferring energy from a power source to an EV via a two-part gapped core transformer in which the two halves of the transformer, i.e., primary and secondary coils, are physically separated from one another. In the present disclosure, the inductive charging system may correspond to an EV power transfer system.

"Inductive coupler": A transformer formed by the primary coil in the primary device or a ground assembly (GA) and the secondary coil in the secondary device or a vehicle assembly (VA) that allows power to be transferred through electric isolation.

"Inductive coupling": A magnetic coupling between two coils. One of the two coils may refer to a primary coil or GA coil, and the other one of the two coils may refer to a secondary coil or vehicle assembly VA coil.

"Supply Power Circuit (SPC) or "Ground assembly (GA)": An assembly disposed on a primary device or the ground assembly or an infrastructure side including the primary coil (or GA coil) and other components. The other components may include at least one part to control the impedance and resonant frequency, a ferrite enforcing the magnetic path, and electromagnetic shielding materials. For example, the SPC or GA may include a power/frequency conversion unit and a SPC controller (or GA controller) necessary to function as a power source of a wireless power charging system, a wiring from the grid, and wirings between each unit, filtering circuits, and a housing.

"EV power circuit (EVPC)" or "Vehicle assembly (VA)": An assembly mounted on the vehicle including the secondary coil (or VA Coil) and other components. The other components may include at least one part to control the impedance and resonant frequency, a ferrite enforcing the magnetic path, and electromagnetic shielding materials. For example, the EVPC or VA may include a power/frequency conversion unit and a EVPC controller (or VA controller) necessary to as the vehicle part of a wireless power charging system, wiring to the vehicle batteries, and wirings between each unit, filtering circuits, and a housing.

The SPC may be referred to as or identified by the ground assembly (GA) or the like. Similarly, the EVPC may be referred to as or identified by the vehicle assembly (VA) or the like.

The GA may be referred to as the primary device, or the like, and the VA may be referred to as the EV device, the secondary device, or the like.

The GA may be referred to as the supply device, a power supply side device, or the like, and the VA may be referred to as the EV device, an EV side device, or the like.

"Primary device": An apparatus providing the contactless coupling to the secondary device. In other words, the primary device may be an apparatus external to an EV. When the EV is receiving power, the primary device may operate as the source of the power to be transferred. The primary device may include the housing and all covers.

"Secondary device": An apparatus mounted on the EV providing the contactless coupling to the primary device. In other words, the secondary device may be provided within the EV. When the EV is receiving power, the secondary device may transfer the power from the primary device to the EV. The secondary device may include the housing and all covers.

"Supply Power Electronics" indicates a portion of the SPC or GA regulating an output power level of the primary coil (or GA Coil) based on information from the vehicle. "EV Power Electronics" indicates a portion of the EVPC or VA monitoring specific on-vehicle parameters during the charging and initiating communications with the EVPC or GA to facilitate the adjustment of the output power level.

The Supply Power Electronics may be referred to as GA electronics, a GA controller, or a primary device communication controller (PDCC), and the EV Power Electronics may be referred to as VA electronics, a VA controller, or an electric vehicle communication controller (EVCC).

"Magnetic gap": A vertical distance between the plane of the higher of the top of the litz wire or the top of the magnetic material in the primary coil/GA Coil to the plane of the lower of the bottom of the litz wire or the magnetic material in the secondary coil/VA Coil when aligned.

"Ambient temperature": A ground-level temperature of the air measured at a subsystem under consideration and not in direct sun light.

"Vehicle ground clearance": A vertical distance between a ground surface and a lowest part of a vehicle floor pan.

"Vehicle magnetic ground clearance": A vertical distance between the plane of the lower of the bottom of the litz wire or the magnetic material in the secondary coil or VA Coil mounted on the vehicle to the ground surface.

"Secondary coil surface distance" or "VA coil magnetic surface distance": A distance between a plane of a nearest magnetic or conducting component surface to a lower external surface of the secondary coil or VA coil when mounted. Such a distance may include any protective coverings and additional items which may be packaged in the secondary coil or VA coil enclosure.

The secondary coil may be referred to as the VA coil, a vehicle coil, or a receiver coil. Similarly, the primary coil may be referred to as the GA coil or a transmit coil.

"Exposed conductive component": A conductive component of electrical equipment (e.g., an electric vehicle) that may be touched, and is not normally energized but may become energized when a fault occurs.

"Hazardous live component": A live component which, under certain conditions, may generate a harmful electric shock.

"Live component": Any conductor or conductive component intended to be electrically energized in normal use.

"Direct contact": A contact of a person with a live component. See IEC 61140 standard.

"Indirect contact": A contact of a person with exposed, conductive, and energized components made live by an insulation failure. See IEC 61140 standard.

"Alignment": A process of finding a relative position of the secondary device with respect to the primary device and/or a relative position of the primary device with respect to the secondary device for an efficient power transfer. In the present disclosure, the alignment may be directed to the alignment in the wireless power transfer system but may not be limited thereto.

"Pairing": A process of associating the vehicle (EV) with a single dedicated supply device (primary device) disposed such that the power transfer may occur. The pairing may include a process of associating the EVPC or VA controller with the SPC or GA controller of the charging spot.

The correlation or association process may include a process of establishing a relationship between two peer communication entities.

"Command and control communications": Communications for exchanging information required for starting, controlling, and ending the wireless power transfer process between an electric vehicle supply equipment and an electric vehicle.

"High-level communication (HLC)": A digital communication capable of handling all information not covered by the command and control communications. The data link of the HLC may use a power line communication (PLC) but is not limited thereto.

"Low-power excitation (LPE)": A technique of activating the supply device (or primary device) for the fine positioning and pairing so that the EV may detect the supply device, and vice versa.

"Service set identifier (SSID)": A unique identifier including 32-characters attached to a header of a packet transmitted on a wireless LAN. The SSID identifies the basic service set (BSS) to which the wireless device attempts to connect. The SSID distinguishes multiple wireless LANs. Therefore, all access points (APs) and all terminal/station devices that want to use a specific wireless LAN may use the same SSID. Devices that do not use a unique SSID are not able to join the BSS. Because the SSID is shown as plain text, the SSID may not provide any security features to the network.

"Extended service set identifier (ESSID)": A name of the network to which one desires to connect. ESSID is similar to SSID but a more extended concept.

"Basic service set identifier (BSSID)": BSSID including 48bits is used to distinguish a specific BSS. With an infrastructure BSS network, the BSSID may be configured for medium access control (MAC) of the AP equipment. For an independent BSS or Ad-hoc network, the BSSID may be generated with any value.

The charging station may include at least one GA and at least one GA controller configured to manage the at least one GA. The GA may include at least one wireless communication device. The charging station may refer to a place or location including at least one GA, which is provided in home, office, public place, road, parking area, etc.

In the present specification, "association" may be used as a term representing a procedure for establishing wireless communication between the electric vehicle communication controller (EVCC) and the supply equipment communication controller (SECC) controlling the charging infrastructure.

The electric vehicle charging system may include a conductive charging system using a cable or a non-contact wireless power transfer system, but is not limited thereto. The electric vehicle charging system may be defined as a system that charges the battery mounted in the electric vehicle using electric power obtained from a commercial power grid or stored in an energy storage device and may have various forms depending on a type of the electric vehicle.

SAE TIR J2954 standard, which is one of the most representative industrial standards for wireless charging, establishes industry-standard specification guidelines that define acceptable criteria for interoperability, electromagnetic compatibility, minimum performance, safety and testing for wireless charging of light-duty electric and plug-in electric vehicles.

As an example of the wireless charging system, the wireless charging system (WCS) according to the J2954 standard may include a grid interface, a high frequency power inverter, power transfer coils, a filter, a rectifier, an optional regulator, and communication circuits between the vehicle energy charging/storage system and a grid connected power inverter. The grid interface may be similar to a conventional EVSE connection for single or three-phase AC power.

Exemplary embodiments of the present disclosure will now be described in detail with reference to the accompanying drawings. In the drawings, the same components may be designated by the same reference numerals to facilitate overall understanding of the disclosure, and duplicate descriptions thereof will be omitted for simplicity.

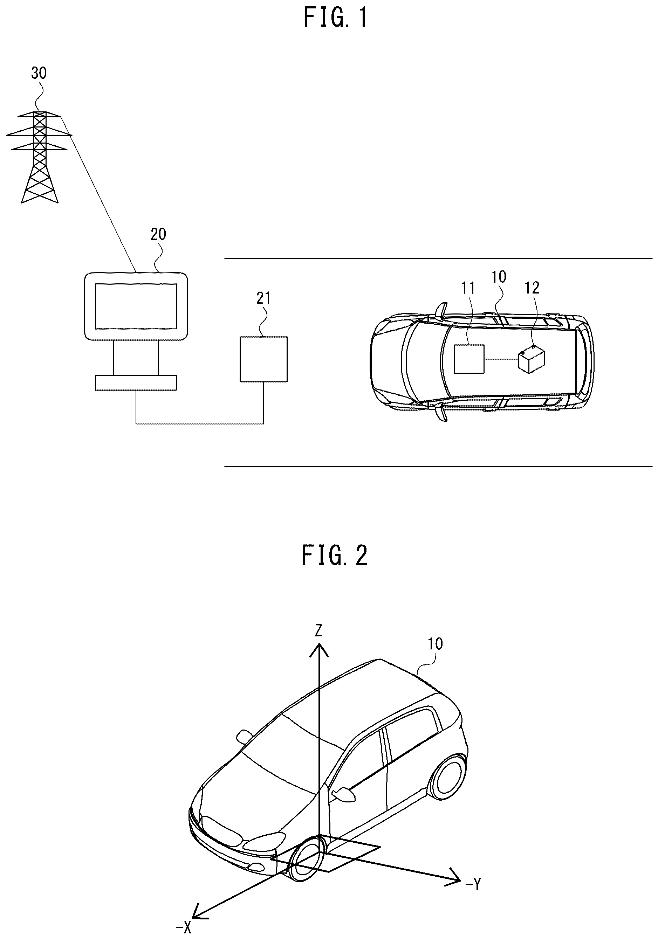

FIG. 1 is an illustration of a wireless power transfer system to which an exemplary embodiment of the present disclosure may be applied.

As shown in FIG. 1, the wireless power transfer may be performed by at least one component of an electric vehicle (EV) 10 and a charging station 20 and may be used to transfer electric power to the EV 10 without any conductive wiring.

The EV 10 according to an exemplary embodiment of the present disclosure may include a hybrid electric vehicle (HEV) having an electric motor as well as an internal combustion engine, and may include not only an automobile but also a motorcycle, a cart, a scooter, and an electric bicycle.

The EV 10 may generally be defined as a vehicle that supplies an electric power derived from a rechargeable energy storage such as a battery 12 to an electric motor in a power train system of the EV 10.

The EV 10 may include a power reception pad 11 having a reception coil suitable for receiving the electric power for charging the battery 12 by the wireless power transfer and may include a plug receptacle or inlet suitable for receiving the electric power for charging the battery 12 by the conductive charging. In particular, the EV 10 configured for conductively charging the battery 12 may be referred to as the plug-in electric vehicle (PEV).

The charging station 20 may be connected to the power grid 30 or a power backbone, and may provide the AC power received from the power grid 30 or the power backbone to a power transmission pad 21 having a transmission coil through a power link.

The charging station 20 may communicate with the power grid 300, or an infrastructure management system or an infrastructure server managing the power grid, and may be configured to perform wireless communications with the EV 10. The wireless communications may be performed through Bluetooth, Zigbee, cellular, wireless local area network (WLAN), or the like.

In addition, for example, the charging station 20 may be located at various places including a parking area of the owner's house of the EV 10, a parking lot for charging the EV at a gas station, a parking lot at a shopping center or a workplace, or the like, but is not limited thereto.

The wireless power transfer to the battery 12 of the EV 10 may be performed as follows. First, the power reception pad 11 of the EV 10 is disposed in an energy field over the power transmission pad 21. Then the reception coil in the power reception pad 11 and the transmission coil in the power transmission pad 21 may be coupled to and interact with each other. An electromotive force may be induced in the power reception pad 11 as a result of the coupling or the interaction, and the battery 12 may be charged by the induced electromotive force.

The charging station 20 and the power transmission pad 21 as a whole or in part may be referred to as the supply power circuit (SPC) or the ground assembly (GA), of which meaning and function were defined above.

Also, the power reception pad 11 along with all or some of the other internal components of the EV 10 may be referred to as the EV power circuit (EVPC) or the vehicle assembly (VA), of which meaning and function were defined above.

Here, each of the power transmission pad 21 and the power reception pad 11 may be configured as a non-polarized or polarized pad.

The non-polarized pad may have one pole in a center of the pad and an opposite pole around its periphery. In this case, the magnetic flux may be formed to exit from the pole in the center of the pad and return to the pole in the periphery from outside of the pad.

The polarized pad may have two poles arranged symmetrically at opposite positions on the pad. In this case, the magnetic flux may be formed according to the orientation of the pad.

In the present specification, the power transmission pad 21 and the power reception pad 11 may be collectively referred to as wireless charging pads.

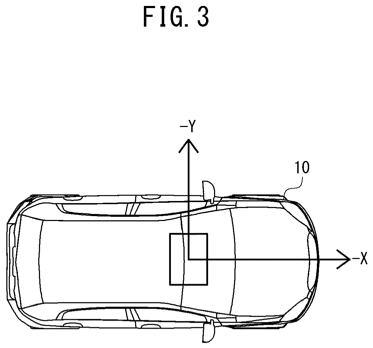

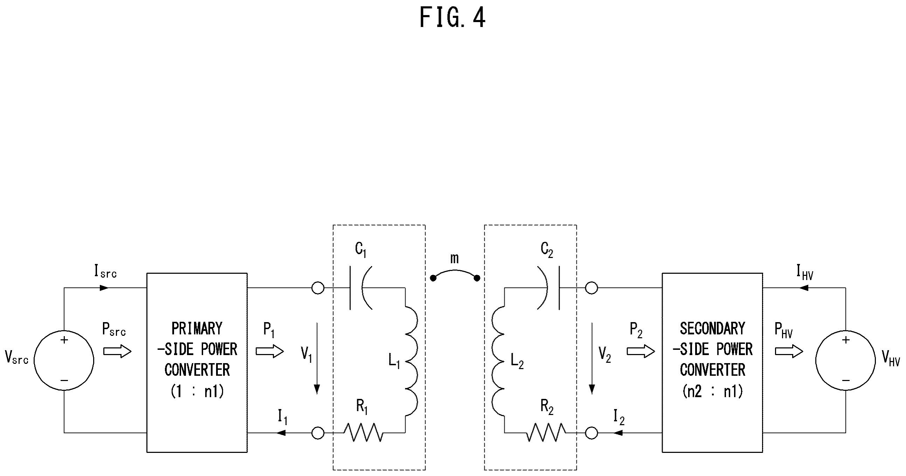

FIGS. 3 and 4 illustrate a Cartesian coordinate system compatible with a definition in the SAE J2954 standard and applicable to an embodiment of the present disclosure.

As shown in FIGS. 2 and 3, in the right-handed Cartesian coordinate system, +X axis may be set to point to the rear of the vehicle, and -X axis may be set to point to the front of the vehicle. +Y axis may be set to point to the right of the vehicle, i.e. to a passenger side of a left-hand drive car, and -Y axis may be set to point to the left of the vehicle in an exemplary embodiment. +Z axis may be set to point to the upward direction, and -Z axis may be set to point to the downward direction. The magnetic center of a coil of the power transmission pad 21 or the power reception pad 11 may be defined as x=0 and y=0, and a ground surface may be defined as z=0.

FIG. 4 is a circuit diagram of an equivalent circuit of an electric vehicle wireless charging circuit according to an exemplary embodiment of the present disclosure.

A left portion of the circuit shown in FIG. 4 may be interpreted as a representation of all or part of a power supply Vsrc supplied from the power grid and a charging station 20 including the power transmission pad 21, and a right portion of the circuit shown in FIG. 4 may be interpreted as a representation of all or part of the electric vehicle including the power reception pad and the battery.

The left portion of the circuit shown in FIG. 4 may provide an output power Psrc corresponding to the power source Vsrc supplied from the power grid to a primary-side power converter. The primary-side power converter may perform a frequency-conversion and AC-DC or DC-to-AC conversion of the power Psrc to output a converted output power P1 to a transmission coil L1, so that the transmission coil L1 may generate an electromagnetic field at a desired operating frequency.

The primary-side power converter may include an AC-DC converter configured to convert the power Psrc which is an AC power supplied from the power grid into a DC power and a low-frequency (LF) converter configured to convert the DC power into an AC power having an operating frequency suitable for the wireless charging. For example, the operating frequency for the wireless charging may be determined to be in a frequency range 80-90 kHz, but is not limited thereto.

The power P1 output by the primary-side power converter may be supplied to a circuit including the transmission coil L1, a first capacitor C1, and a first resistor R1. In particular, a capacitance of the first capacitor C1 may be determined as a value establishing the operating frequency suitable for the wireless charging together with the transmission coil L1. The first resistor R1 may represent a power loss in the transmission coil L1 and the first capacitor C1.

Further, the transmission coil L1 may be electromagnetically coupled with a reception coil L2 by a coupling coefficient m so that a power P2 is transferred to the reception coil L2 or the power P2 is induced in the reception coil L2. Therefore, the meaning of power transfer in the present disclosure may be used interchangeably with the meaning of power induction.

The power P2 induced in or transferred to the reception coil L2 may be provided to a secondary-side power converter. Particularly, a capacitance of a second capacitor C2 may be determined as a value establishing the operating frequency suitable for the wireless charging together with the reception coil L2. A second resistor R2 may represent a power loss in the reception coil L2 and the second capacitor C2.

The secondary-side power converter may include an AC-DC converter configured to convert the supplied power P2 of the operating frequency to a DC power having a voltage level suitable for the battery VHV of the EV.

The electric power PHV converted from the power P2 supplied to the secondary-side power converter may be used for charging the battery VHV mounted inside the EV.

The right portion of the circuit shown in FIG. 4 may further include a switch for selectively connecting or disconnecting the reception coil L2 with the battery VHV.

Resonance frequencies of the transmission coil L1 and the reception coil L2 may be similar or identical to each other, and the reception coil L2 may be positioned in the electromagnetic field generated by the transmission coil L1.

It should be noted that the circuit of FIG. 4 is illustrative for the WPT in the EV WPT system used for exemplary embodiments of the present disclosure, and the present disclosure is not limited to the circuit illustrated in FIG. 4.

On the other hand, since the power loss may increase with a distance between the transmission coil L1 and the reception coil L2, it may be an important factor to set the relative positions of the transmission coil L1 and the reception coil L2 appropriately.

The transmission coil L1 may be included in the transmission pad 21 shown in FIG. 1, and the reception coil L2 may be included in the reception pad 11 shown in FIG. 1. Additionally, the transmission coil may be referred to as the primary coil or a ground assembly (GA) coil, and the reception coil may be referred to as the secondary coil or a vehicle assembly (VA) coil. Therefore, a positional alignment between the transmission pad and the reception pad or a positional alignment between the EV and the transmission pad may be an important factor also.

The positional alignment between the transmission pad 21 and the reception pad 11 in the electric vehicle 10 shown in FIG. 1 may correspond to the term "alignment" described above and therefore may be defined as the positional alignment between the SPC/GA and the EVPC/VA and is not limited to the positional alignment of the transmission pad 21 and the reception pad 11.

The transmission pad 21 may be positioned below the ground surface, may be positioned on the ground surface, or may be positioned below the ground surface with its top surface being exposed over the ground surface. At this time, as shown in FIGS. 2 and 3, the x-axis may indicate the front-to-back direction of the vehicle, the y-axis may indicate the left--right direction of the vehicle, and the z-axis may indicate the up- and-down direction of the vehicle.

In addition, the reception pad 11 of the EV may be defined by different categories according to height (defined in the z-direction) measured from the ground surface. For example, the reception pad 11 having a height of about 100-150 millimeters (mm) from the ground surface may be categorized into a class 1. The reception pad 11 having a height of about 140-210 mm may be categorized into a class 2. The reception pad 11 having a height of about 170-250 mm may be categorized into a class 3. The reception pad may support only some of the classes 1 through 3. For example, only the class 1 may be supported by the reception pad 11, or the class 1 and 2 may be supported by the reception pad 11.

The height of the reception pad measured from the ground surface may correspond to the previously defined term "vehicle magnetic ground clearance."

Meanwhile, a vertical position (i.e., position in the z-direction) of the power transmission pad 21 may be determined to be disposed between the maximum class and the minimum class supported by the power reception pad 11. For example, in case that the reception pad supports only the class 1 and 2, the vertical position of the power transmission pad 21 may be in a range between about 100 and 210 mm with respect to the power reception pad 11.

In addition, a gap between the center of the power transmission pad 21 and the center of the power reception pad 11 may be determined to be disposed within the limits of the horizontal and vertical directions (defined in the x- and y-directions). For example, the gap (e.g., Δy) may be determined to be within ±75 mm in a lateral direction (defined in the y-direction), and within ±100 mm in the longitudinal direction (defined in the x-direction).

The relative positions of the power transmission pad 21 and the power reception pad 11 may be varied in accordance with experimental results, and it should be noted that the numerical values mentioned above are provided as examples.

Although the alignment between the pads has been described above on the assumption that each of the transmission pad 21 and the reception pad 11 includes a coil, the alignment between the pads may be defined more specifically by an alignment between the transmission coil (or GA coil) and the reception coil (or VA coil) included in the transmission pad 21 and the reception pad 11, respectively.

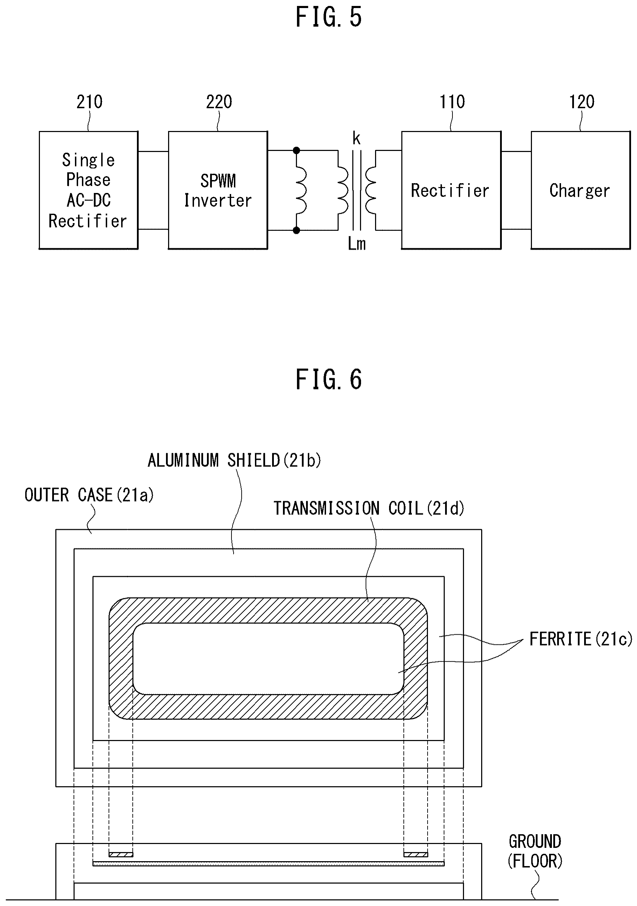

FIG. 5 shows an equivalent circuit of a single-phase to single-phase wireless power transfer (WPT) system according to an exemplary embodiment of the present disclosure.

A magnetic/inductive coupling or resonance structure formed between the primary coil and the secondary coil according to various embodiments of the present disclosure may be represented equivalently by a transformer shown in FIG. 5.

As shown in FIG. 5, a single-phase rectifier 210 and a sinusoidal pulse width modulation (SPWM) inverter 220 for applying an alternating current power to the primary coil may be disposed on a side of the primary coil.

In addition, a rectifier 110 and a charger 120 for transferring the power from the secondary coil 101C to the load or battery may be disposed on a side of the secondary coil.

The wireless power transfer system according to an exemplary embodiment of the present disclosure may include a power transfer circuit. The power transfer circuit shown in FIG. 5 may include a structure comprised of the single-phase rectifier 210 and the SPWM inverter 220 on the primary coil side as a technical feature.

The power transfer circuit according to an exemplary embodiment of the present disclosure shown in FIG. 5 may employ a proportional integral (PI) control scheme based on a measurement of the single-phase rectifier 210, as a technical feature, to control the single-phase rectifier 210 and the SPWM inverter 220 applying an alternating current power to the primary coil.

The SPWM inverter 220 may receive an output of the single-phase rectifier 210 and generate the alternating current power to supply the alternating current power as an output to the primary coil.

Meanwhile, an alternating current power rectified by the rectifier 110 may be supplied to the battery by the charger 120 to recharge the battery.

FIG. 6 is a conceptual cross sectional view and an elevation view of the transmission pad 21 according to an exemplary embodiment of the present disclosure.

In FIG. 6, there is shown a transmission coil 21d that may be included in the transmission pad 21 in a device performing the wireless power transfer by a single-phase operation, for example, in the device shown in FIG. 5. The transmission pad 21 shown in FIG. 6 may support the single-phase operation mode. If the reception pad 11 includes the reception coil (not shown) having a shape corresponding to the transmission coil of FIG. 6, the reception pad 11 can perform the wireless power reception in the single-phase operation mode. The configuration of the coil and hardware of the reception pad 11 needed for the single-phase operation mode may be easily implemented by a person skilled in the art by modifying the transmission pad of FIG. 6.

As shown in FIG. 6, the power transmission pad 21 may include an outer case 21a forming an outer structure of the power transmission pad 21, an aluminum shield 21b having a shape of a planar plate and installed inside the outer case 21a, and a ferrite pad 21c installed on or above the aluminum shield 21b, and a transmission coil 21d installed on or above ferrite pad 21c. Here, "on or above" means an upward direction relative to the ground where the power transmission pad 21 is installed.

Here, the ferrite which is used for the ferrite pad 21c is a magnetic material containing iron oxide and can affect the wireless power transfer by reducing a magnetic resistance and facilitating a flow of magnetic flux.

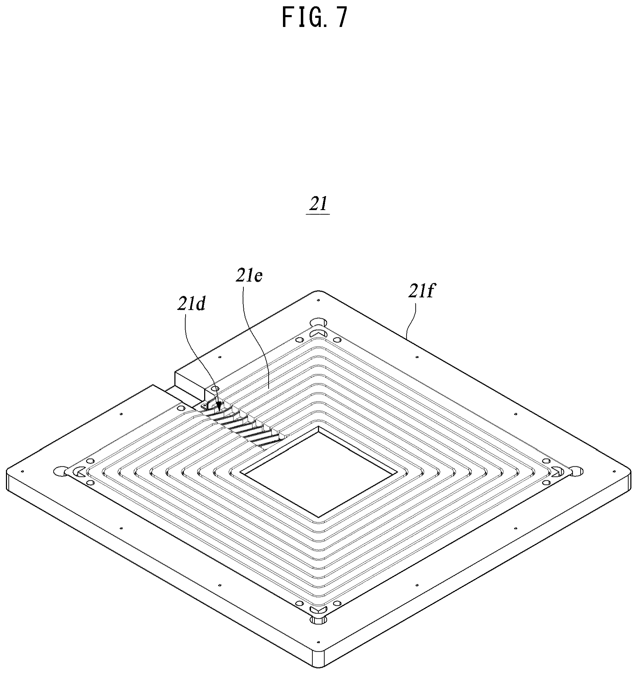

FIG. 7 is a perspective view illustrating a transmission pad according to a related art exemplary embodiment.

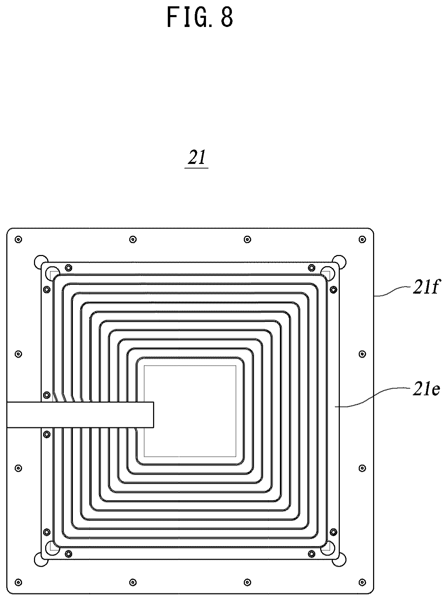

FIG. 8 is a diagram schematically illustrating a structure of a winding frame of a transmission pad according to a related art exemplary embodiment.

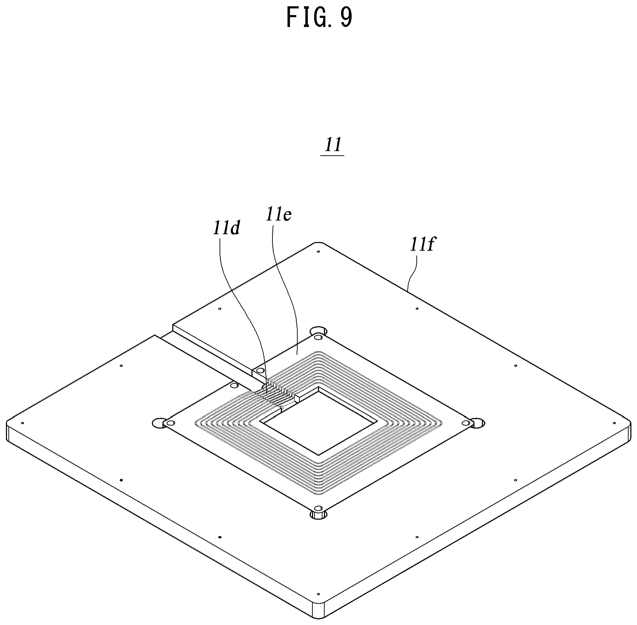

FIG. 9 is a perspective view illustrating a reception pad according to a related art exemplary embodiment.

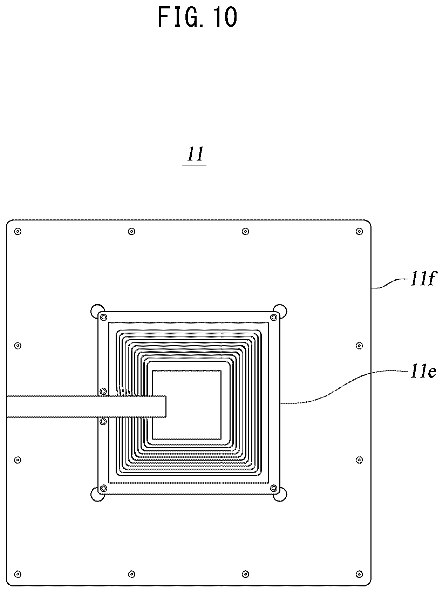

FIG. 10 is a diagram schematically illustrating a structure of a winding frame of a reception pad according to a related art exemplary embodiment.

Hereinafter, FIGS. 7 and 10 will be collectively referred to for description.

A wireless charging system for wirelessly charging an electric vehicle or an electric mobility (hereinafter referred to as a vehicle) may include a transmission pad 21 installed on the ground and a reception pad 11 installed on the vehicle. In the present disclosure, the transmission pad 21 on an electric vehicle supply equipment (EVSE) (or charging station) side and the reception pad 11 on an electric mobility side may collectively be referred to as a wireless charging pad.

The reception pad 11 may charge a battery of the vehicle by using power transmitted from the transmission pad 21.

The wireless charging pad 11, 21 may include a core (not shown), windings (or coils) 11d, 21d, inner winding frames 11e, 21e, outer winding frames 11f, 21f, and an aluminum plate (not shown).

The core provides a path of magnetic flux, and the windings 11d, 21d may provide a path of current.

The winding frames 11f, 21f may fix the windings 11d, 21d to maintain structures of the wireless charging pads 11, 21.

The aluminum plate may perform functions of electromagnetic interference (EMI) shielding and heat dissipation of the core.

In the wireless charging pads 11, 21 of the related art, the inner winding frames 11e, 21e may be formed such that the windings (or coils) 11d, 21d are in close contact with the inner winding frames 11e, 21e. For example, as shown in FIGS. 8 and 10, the coils 11d, 21d are wound to surround a central space from an inner bottom surface of the outer winding frames 11f, 21f, and protrusions of the inner winding frames are inserted into spaces formed between segments of the coils so that the coils are sealed inside the inner winding frames 11e, 21e.

A segment of the coils 11d, 21d may mean a portion of the coil that forms one turn when the coil is wound once around the inner winding frame 11e, 21e. For example, a portion of the coil that forms a first turn when the coil 11d, 21d is first wound once may be referred to as a first segment, and a portion of the coil that forms a next turn may be referred to as a second segment.

As described above, in the structure in which the coils and the winding frames of the transmission pad 21 and the reception pad 11 are in close contact and sealed, heat generated from the windings 11d, 21d may not be effectively released to the outside. Therefore, in the wireless charging system of the related art, heat generated from the windings and other components is accumulated, thereby reducing stability and decreasing wireless charging efficiency.

The present disclosure intends to provide a technology for overcoming the above-described disadvantages that make heat dissipation difficult due to the close contact and sealing between the windings and the winding frames.

The present disclosure is directed to implementing means for preventing overheating of electric vehicle components and wireless charging pads caused by a magnetic field generated in a power supply device among safety requirements related to wireless charging of electric vehicles.

Particularly, a wireless charging pad for an electric vehicle according to an exemplary embodiment of the present disclosure can optimize a heat conduction path by changing a structure of a winding frame, which is one of components of the wireless charging pad. In addition, the present disclosure can improve stability and enhance wireless charging efficiency by adopting a forced air cooling heat dissipation method to effectively dissipate heat generated from the windings.

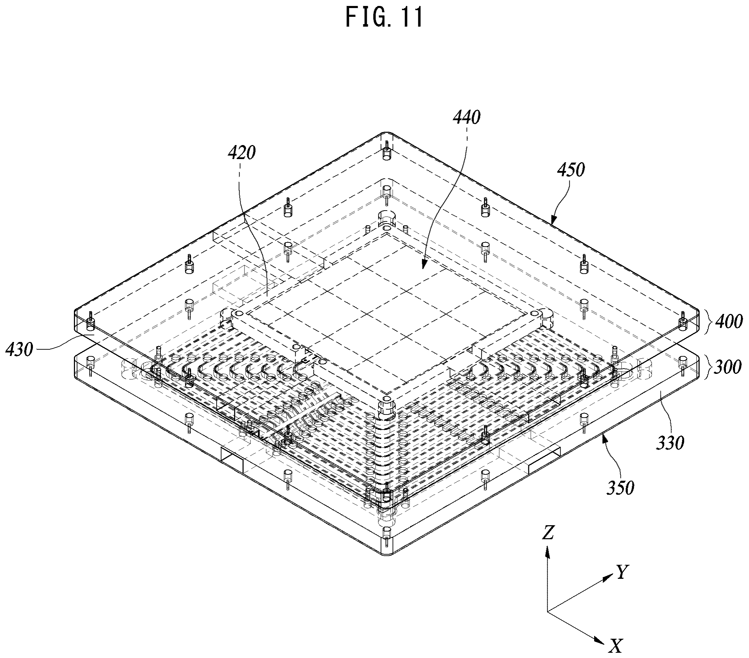

FIG. 11 is a perspective view illustrating transmission and reception pads according to an exemplary embodiment of the present disclosure.

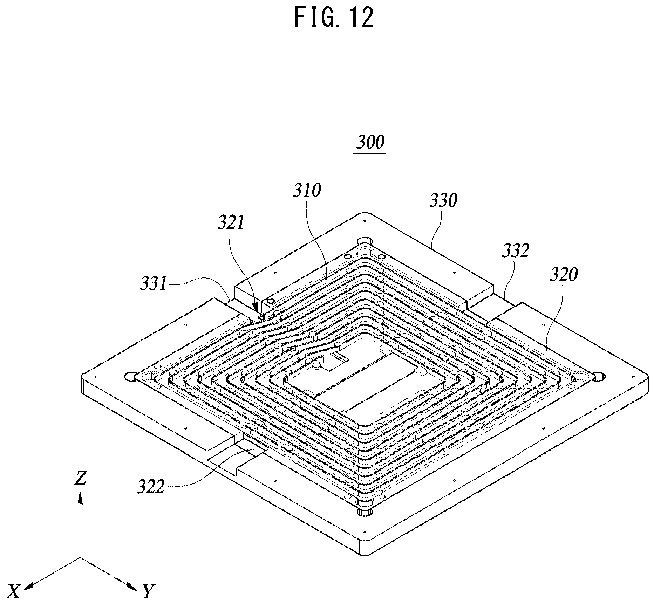

FIG. 12 is a perspective view illustrating a transmission pad according to an exemplary embodiment of the present disclosure.

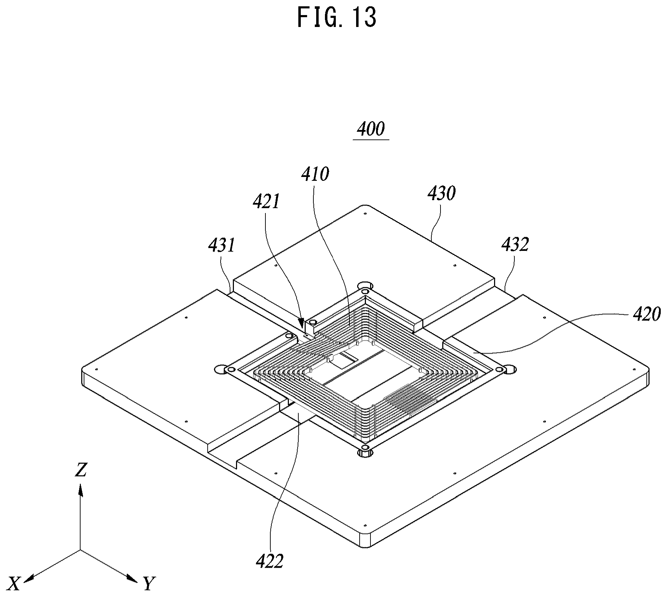

FIG. 13 is a perspective view illustrating a reception pad according to an exemplary embodiment of the present disclosure.

Hereinafter, FIGS. 11 to 13 will be collectively referred to for description.

A transmission pad 300 may include winding frames 320, 330, a coil 310 wound on the winding frames, a ferrite core (not shown), and an aluminum plate 350.

The winding frames may include an inner winding frame 320 and an outer winding frame 330. The winding frame may also be referred to as a winding support plate or a Litz tray.

The coil 310 may be wound in or within the inner winding frame 320 so as to surround a central space.

A reception pad 400 may include winding frames 420, 430, a coil 410 wound on the winding frames, a ferrite core 440, and an aluminum plate 450.

The inner winding frames 320, 420 may be combined with one side surface of the outer winding frames 330, 430 in an insertion manner to form a single winding frame.

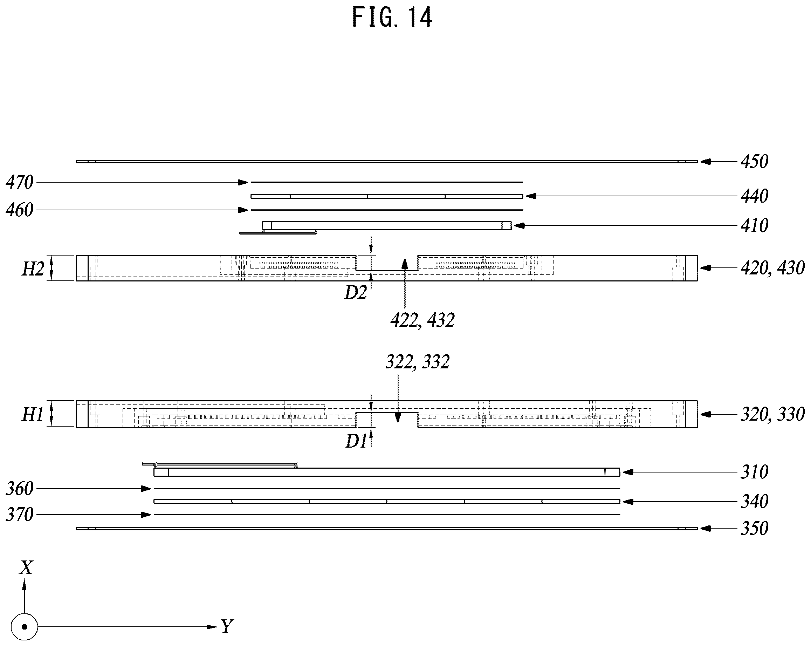

FIG. 14 is an exploded cross-sectional view illustrating the transmission pad and the reception pad shown in FIG. 11.

Hereinafter, FIGS. 11 to 14 will be collectively referred to for description.

A ferrite core 340 of the transmission pad 300 may be disposed above a coil 310 wound on winding frames 320 and 330. According to exemplary embodiments, an insulating pad 360 may be included between the coil 310 and the ferrite core 340. An aluminum plate 350 may be disposed above the ferrite core 340. According to exemplary embodiments, an insulating pad 370 may be included between the ferrite core 340 and the aluminum plate 350. In the present disclosure, the aluminum plate may also be referred to as an aluminum shield.

A winding structure of the transmission pad 300 may be maintained in shape by the winding frames 320, 330 and the aluminum plate 350.

As shown in FIGS. 11, 12, and 14, winding frames 320, 330 may have recessed portions in the form of slots, referred to as flow grooves 322, 332, formed therein so that air introduced from the outside may flow therethrough. That is, the winding frames 320, 330 may have the flow grooves 322, 332 formed therein such that air introduced from a first side surface of the winding frames 320, 330 is discharged toward second side surfaces of the winding frames 320, 330. For example, in an exemplary embodiment of the present disclosure, the flow grooves 322, 332 may extend from a central portion of the winding frames 320, 330 toward both sides.

The flow grooves 322, 332 may be formed under the coil 310. Therefore, a space may be formed between the inner winding frame 320 and the coil 310.

A direction in which the flow grooves 322, 332 extend may be perpendicular to a direction in which inlet and outlet grooves 321, 331 formed in the winding frames 320, 330 extend to connect both end portions of the coil 310 to the outside. In the present disclosure, the inlet and outlet grooves 321, 331 may also be referred to as inlet and outlet portions.

Air flow paths may be formed in the winding frames 320, 330 such that air introduced from the first side surfaces is discharged toward the inlet and outlet portions of the coil 310.

A ferrite core 440 of the reception pad 400 may be disposed above a coil 410 wound on winding frames 420 and 430. According to exemplary embodiments, an insulating pad 460 may be included between the coil 410 and the ferrite core 440. An aluminum plate 450 may be disposed above the ferrite core 440. According to exemplary embodiments, an insulating pad 470 may be included between the ferrite core 440 and the aluminum plate 450.

A winding structure of the reception pad 400 may be maintained in shape by the winding frames 420, 430 and the aluminum plate 450.

As shown in FIGS. 11, 13, and 14, winding frames 420, 430 may have flow grooves 422, 432 formed therein so that air introduced from the outside may flow therethrough. That is, the winding frames 420, 430 may have the flow grooves 422, 432 formed therein such that air introduced from a first side surface of the winding frames 420, 430 is discharged toward second side surfaces of the winding frames 420, 430. Through such configuration of the flow grooves, air cooling heat dissipation may be achieved.

For example, in an exemplary embodiment of the present disclosure, the flow grooves 422, 432 may extend from a central portion of the winding frames 420, 430 toward both sides.

The flow grooves 422, 432 may be formed under the coil 410. Therefore, a space may be formed between the inner winding frame 420 and the coil 410.

A direction in which the flow grooves 422, 432 extend may be perpendicular to a direction in which inlet and outlet grooves 421, 431 formed in the winding frames 420, 430 extend to connect both end portions of the coil 410 to the outside. In the present disclosure, the inlet and outlet grooves 421, 431 may also be referred to as inlet and outlet portions.

Air flow paths may be formed in the winding frames 420, 430 such that air introduced from the first side surfaces is discharged toward the inlet and outlet portions of the coil 410.

A height H1 of the outer winding frame 330 of the transmission pad 300 may be, for example, 33 mm, and a depth D1 of the flow grooves 322, 332 formed in the inner winding frame 320 may be, for example, 22 mm.

A height H2 of the outer winding frame 430 of the reception pad 400 may be, for example, 33 mm, and a depth D2 of the flow grooves 422, 432 formed in the inner winding frame 420 may be, for example, 22 mm.

The height of the outer winding frames and the depth of the flow grooves of the inner winding frames may vary according to exemplary embodiments.

Meanwhile, on the recessed portions, that is, the flow grooves, the ferrite structure may also be formed to have recessed slot-shaped portions. Alternatively, a shape of existing windings and a shape of the ferrite core may not be changed.

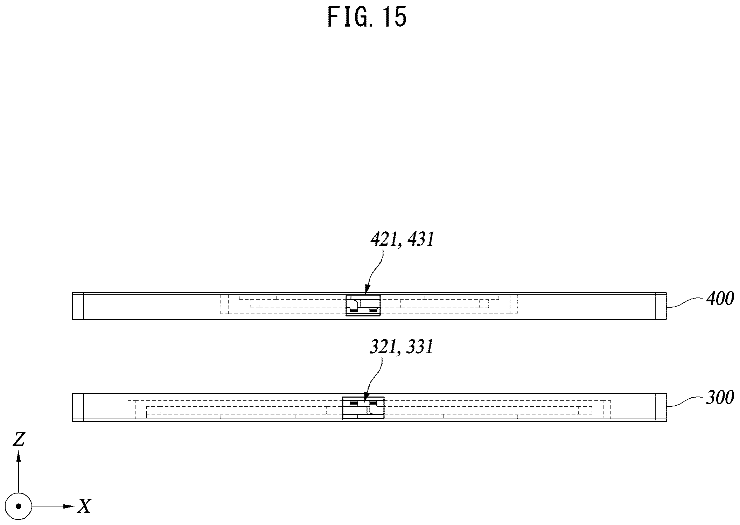

FIG. 15 is a view illustrating sides of the transmission pad and the reception pad of FIG. 11, in which inlet and outlet grooves are formed.

In an inner winding frame 320 of the transmission pad 300, an inlet and outlet groove 321 for inlet and outlet of the coil 310 may be formed from a central portion of the inner winding frame 320 to a side surface from a bottom surface in a first direction, and an inlet and outlet groove 331 may be formed on a side surface of the outer winding frame 330 in the direction extended from the inlet and outlet groove 321.

In an inner winding frame 420 of the reception pad 400, an inlet and outlet groove 421 for inlet and outlet of the coil 410 may be formed from a central portion of the inner winding frame 420 to a side surface from a bottom surface in a second direction, and an inlet and outlet groove 431 may be formed on a side surface of the outer winding frame 430 in the direction extended from the inlet and outlet groove 421. The second direction may be the same as or different from the first direction.

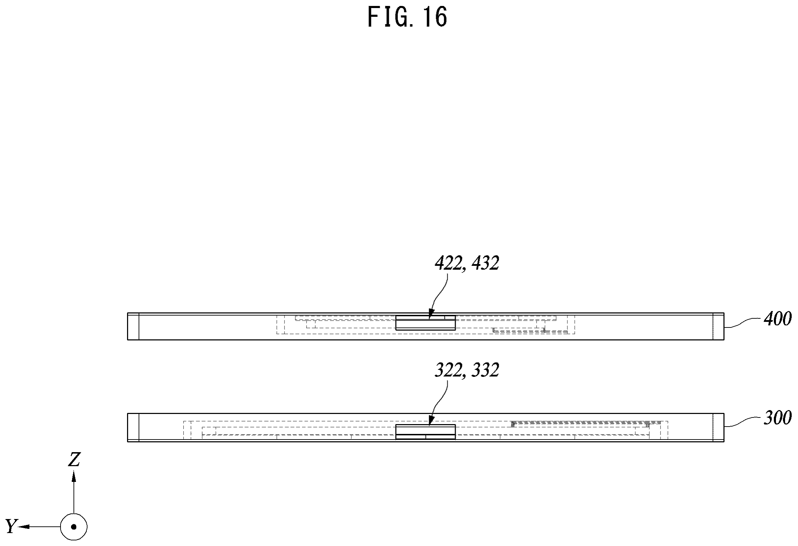

FIG. 16 is a view illustrating sides of the transmission pad and the reception pad of FIG. 11, in which flow grooves are formed.

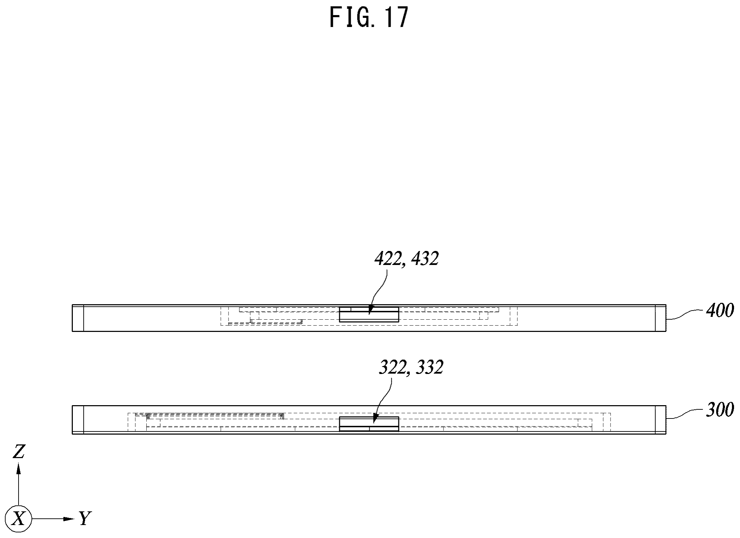

FIG. 17 is a view illustrating the transmission pad and the reception pad of FIG. 16 as viewed from opposite sides.

As shown in FIGS. 14 to 17, portions of coils 310, 410 and portions of ferrite cores 340, 440 may be exposed to the outside through inlet and outlet grooves 321, 331, 421, 431 and flow grooves 322, 332, 422, 432 formed in winding frames 320, 330, 420, 430.

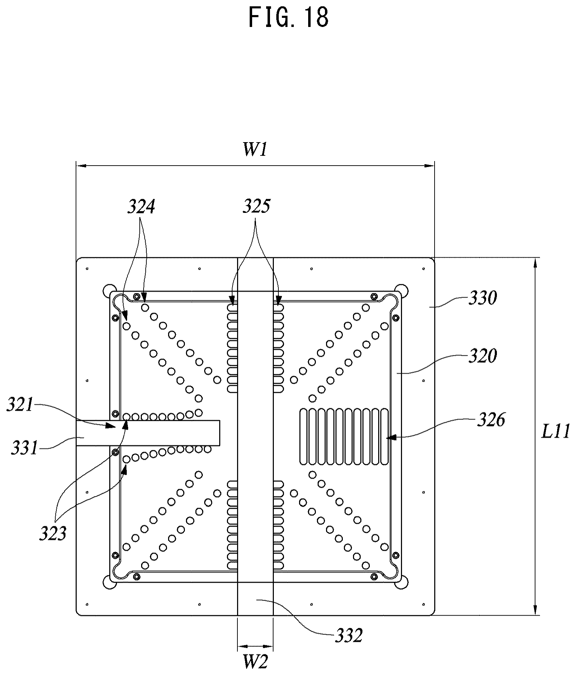

FIG. 18 illustrates a winding frame of the transmission pad according to an exemplary embodiment of the present disclosure.

As shown in FIGS. 7 and 18, an inner winding frame 320 of FIG. 18 may be formed to minimize a contact area between the inner winding frame 320 and a coil 310, unlike a winding frame 21f of FIG. 7. Thus, a plurality of winding guides 323, 324, 325, 326 (hereinafter, referred to as guides) for guiding a winding position of the coil 310 may be formed in the inner winding frame 320. The coil 310 may be wound according to the plurality of guides 323, 324, 325, 326 formed in the inner winding frame 320.

The guides are components existing to maintain a shape of the winding, and guides having shapes that minimize obstruction of air flow may be used in the exemplary embodiment of the present disclosure. For example, as shown in FIG. 18, the shapes of the guides may be circular or rod-shaped, and the shapes of the guides are not limited thereto as long as the above-described purpose may be achieved.

For example, shapes and intervals of the guides may be differently arranged or identically arranged at central portions and corner portions corresponding to four corners of the inner winding frame 320 on a plane.

A first guide set 323 may include two rows of guides, and an interval between the two rows may be identical or different.

A second guide set 324 may include two rows of guides, and an interval between the two rows may be identical.

A third guide set 325 may include guides having shapes different from those of guides included in the second guide set 324. The third guide set 325 may include two rows of guides, and an interval between the two rows may be identical.

A fourth guide set 326 may include one row of guides. Shapes of guides of the fourth guide set 326 may be different from shapes of guides of the second guide set 324 and shapes of guides of the third guide set 325.

Guide sets identical to the second guide set 324 may be formed at each of four corners of the inner winding frame 320. A guide set identical to the third guide set 325 may be formed at a portion symmetrical to a portion where the third guide set 325 is located in the inner winding frame 320.

By the guides described above, the coil may be stably fixed to the winding frame without being sealed therein.

Shapes and arrangement structures of the guides of the inner winding frame 320 may vary according to exemplary embodiments.

A horizontal length W1 and a vertical length L11 of an outer winding frame 330 may be, for example, 800 mm, respectively. The horizontal length and the vertical length of the outer winding frame may vary according to exemplary embodiments. As shown in FIGS. 14 and 18, for example, a horizontal length and a vertical length of an aluminum plate 350 may each be 800 mm, which are identical to those of the outer winding frame 330.

A width W2 of flow grooves 332 of the winding frames 320, 330 may be, for example, 80 mm. The width of the flow grooves may vary according to a width of a fan used for heat dissipation through forced air cooling described later. For example, in an exemplary embodiment, the width of the fan may be, for example, 80 mm.

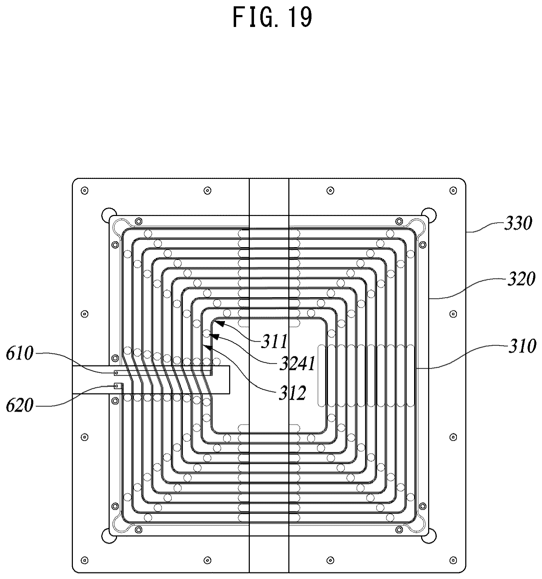

FIG. 19 is a view illustrating a transmission pad in which a coil is wound according to an exemplary embodiment of the present disclosure.

As shown in FIGS. 18 and 19, for example, with respect to an arbitrary guide 3241 of the second guide set 324, one point of the arbitrary guide 3241 may contact one point of a first segment 311 of the wound coil 310, and another point of the arbitrary guide 3241 may contact one point of a second segment 312 of the wound coil 310.

By minimizing contact between the wound coil 310 and the guides formed in the inner winding frame 320, the coil 310 and the inner winding frame 320 may not be in close contact.

As shown in FIGS. 18 and 19, the arrangement structure of the guides described above may be a structure that generates a path for conducting heat generated from the coil. That is, a passage formed between adjacent segments of the coil 310 (for example, between segment 311 and segment 312) may be used as a heat dissipation path described later.

An interval between adjacent and parallel segments such as the first segment 311 and the second segment 312 may vary according to a predetermined first parameter.

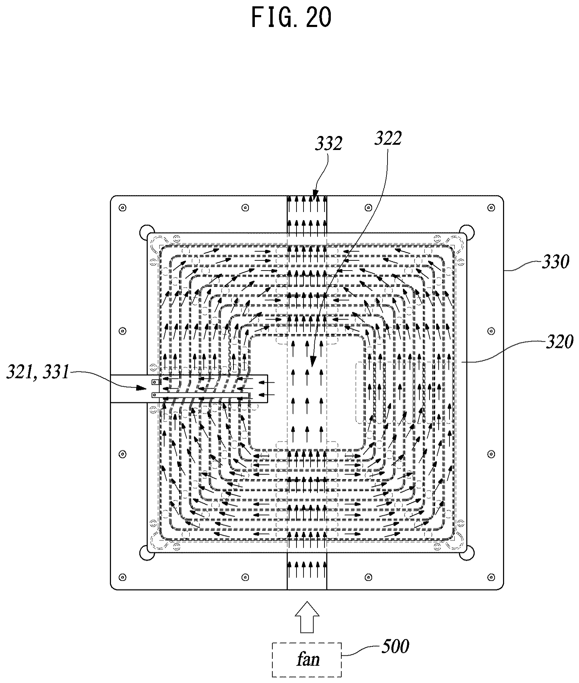

FIG. 20 is a view illustrating a transmission pad and a fan according to an exemplary embodiment of the present disclosure.

FIG. 20 is a bottom view of a state in which only the aluminum plate is added to the transmission pad 300 of FIG. 19.

A fan 500 may be disposed on one side of both sides of flow grooves 322, 332 formed in the winding frames 320, 330 of the transmission pad 300.

When the fan 500 operates, air may be introduced into one side (that is, a first side surface of the inner winding frame 320) of the flow grooves 322, 332 according to an air flow generated from the fan 500. The introduced air may pass through a passage formed by segments of the coil 310 wound according to the guides (for example, between any first segment and any second segment) and may be discharged toward a second side surface (for example, the other side of both sides of the flow grooves 322, 332) of the winding frames 320, 330 or toward inlet and outlet portions 321, 331 of the coil 310 formed in the winding frames 320, 330.

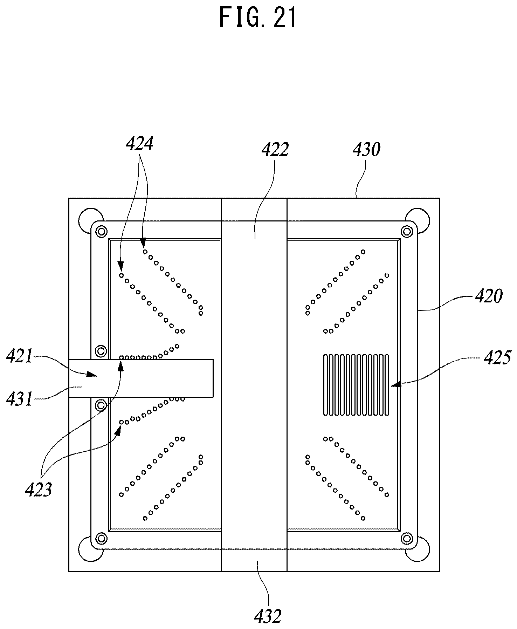

FIG. 21 is a view for describing an inner winding frame of a reception pad according to an exemplary embodiment of the present disclosure.

For convenience of description, FIG. 21 illustrates only a part of an inner winding frame 420 and an outer winding frame 430 among the winding frames 420, 430 of the reception pad 400.

As shown in FIGS. 9 and 21, the inner winding frame 420 of FIG. 21 may be formed to minimize a contact area between the inner winding frame 420 and a coil 410, unlike a winding frame 11f of FIG. 9. Thus, a plurality of guides 423, 424, 425 for guiding a winding position of the coil 410 may be formed in the inner winding frame 420. The coil 410 may be wound according to the plurality of guides 423, 424, 425 formed in the inner winding frame 420.

The guides are components existing to maintain a shape of the winding, and guides having shapes that minimize obstruction of air flow may be used in the exemplary embodiment of the present disclosure. For example, as shown in FIG. 21, the shapes of the guides may be circular or rod-shaped, and the shapes of the guides are not limited thereto as long as the above-described purpose may be achieved.

For example, shapes and intervals of the guides may be differently arranged or identically arranged at portions corresponding to four corners and four edge centers of the inner winding frame 420 on a plane.

For example, an eleventh guide set 423 may include two rows of guides, and an interval between the two rows may be identical or different.

A twelfth guide set 424 may include two rows of guides, and an interval between the two rows may be identical or different.

A thirteenth guide set 425 may include one row of guides. Shapes of the guides of the thirteenth guide set 425 may be different from shapes of the guides of the twelfth guide set 424.

Guide sets identical to the twelfth guide set 424 may be formed at each of four corners of the inner winding frame 420.

Comparing the inner winding frame 320 of the transmission pad 300 of FIG. 18 with the inner winding frame 420 of the reception pad 400 of FIG. 21, a difference may be found in an arrangement shape between the first guide set 323 of the inner winding frame 320 and the eleventh guide set 423 of the inner winding frame 420. In addition, the inner winding frame 320 may include two sets of third guide sets 325 in symmetrical directions, while the inner winding frame 420 may not include guides corresponding to the third guide sets 325.

That is, since the reception pad 400 has a smaller area than the transmission pad 300, the reception pad 400 may maintain the shape of the winding even without the guide structures 325. However, since the transmission pad 300 has a larger winding area than the reception pad 400, a structure serving as the guide 325 may be required to maintain the shape of the winding. According to exemplary embodiments, the reception pad 400 may also include such a structure as in the transmission pad 300.

As shown in FIGS. 11, 18, and 21, when the transmission pad 300 and the reception pad 400 are arranged in parallel, directions in which flow grooves 322, 332 of the winding frames 320, 330 included in the transmission pad 300 extend may be identical to directions in which flow grooves 422, 432 of the winding frames 420, 430 included in the reception pad 400 extend. That is, when a fan is located on one side of both sides of the flow grooves, air introduced into the transmission pad 300 and the reception pad 400 may be introduced from the same direction.

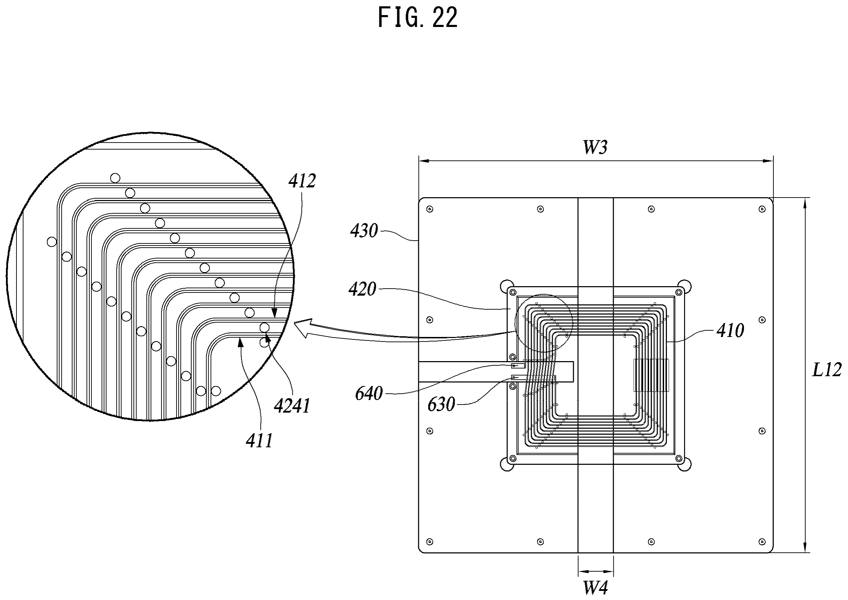

FIG. 22 is a view illustrating a reception pad in which a coil is wound according to an exemplary embodiment of the present disclosure.

A horizontal length W3 and a vertical length L12 of the outer winding frame 430 may each be, for example, 800 mm. The horizontal and vertical lengths of the outer winding frame may vary according to exemplary embodiments. As shown in FIGS. 14 and 22, for example, a horizontal length and a vertical length of an aluminum plate 450 may each be 800 mm, which are identical to those of the outer winding frame 430.

A width W4 of flow grooves 422, 432 of the winding frames 420, 430 may be, for example, 80 mm. The width of the flow grooves may vary according to a width of a fan used for heat dissipation through forced air cooling described later. For example, in an exemplary embodiment, the width of the fan may be, for example, 80 mm.

As shown in FIGS. 19 and 22, a width of the flow grooves 332 of the transmission pad 300 and a width of the flow grooves 432 of the reception pad 400 may be identical or different.

As shown in FIGS. 21 and 22, for example, with respect to an arbitrary guide 4241 of the twelfth guide set 424, one point of the arbitrary guide 4241 may contact one point of a third segment 411 of the wound coil 410, and another point of the arbitrary guide 4241 may contact one point of a fourth segment 412 of the wound coil 410.

By minimizing contact between the wound coil 410 and the guides formed in the inner winding frame 420, the coil 410 and the inner winding frame 420 may not be in close contact.

As shown in FIGS. 21 and 22, the arrangement structure of the guides described above may be a structure that generates a path for conducting heat generated from the coil. That is, a passage formed between adjacent segments of the coil 410 (for example, between segment 411 and segment 412) may be used as a heat dissipation path described later.

An interval between adjacent and parallel segments such as the third segment 411 and the fourth segment 412 may vary according to a predetermined second parameter.

For example, as shown in FIGS. 19 and 22, the predetermined first parameter and the predetermined second parameter may be identical or different.

As shown in FIGS. 19 and 22, a shape of a first connection part 610, where a first end of both ends of the coil 310 of the transmission pad 300 is connected to the outside, and a shape of a second connection part 620, where a second end of both ends of the coil 310 is connected to the outside, may each differ from a shape of a third connection part 630, where a third end of both ends of the coil 410 of the reception pad 400 is connected to the outside, and a shape of a fourth connection part 640, where a fourth end of both ends of the coil 410 is connected to the outside. This may result from structural differences formed for physically manufacturing the coils.

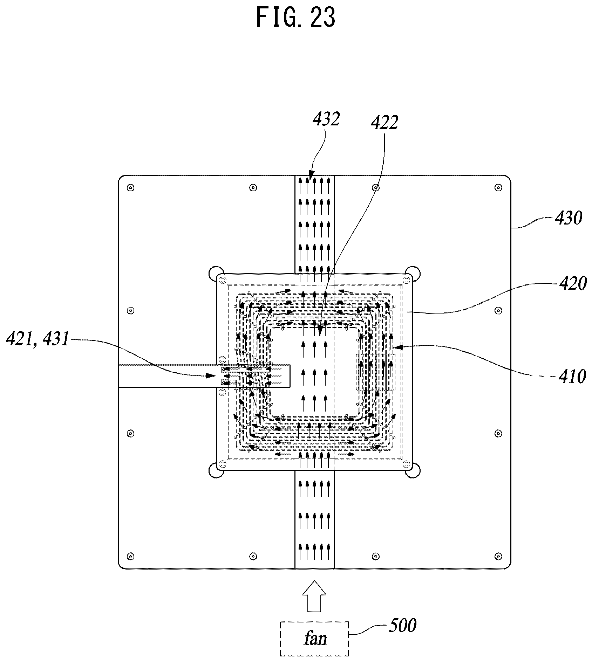

FIG. 23 is a view illustrating a reception pad and a fan according to an exemplary embodiment of the present disclosure.

FIG. 23 is a plan view of a state in which only the aluminum plate is added to the reception pad 400 of FIG. 22.

A fan 500 may be disposed on one side of both sides of flow grooves 422, 432 formed in winding frames 420, 430 of the reception pad 400.

When the fan 500 operates, air may be introduced into one side (that is, a first side surface of the inner winding frame 420) of the flow grooves 422, 432 according to an air flow generated from the fan 500. At this time, the introduced air may pass through a passage formed by segments of the coil 410 wound according to the guides (for example, between any first segment and any second segment) and may be discharged toward a second side surface (for example, the other side of both sides of the flow grooves 422, 432) of the winding frames 420, 430 or toward inlet and outlet portions 421, 431 of the coil 410 formed in the winding frames 420, 430.

According to the present disclosure, slots may be formed on both sides of the winding frame to form air flow paths through inlet and outlet portions of the winding and through the slots. Thus, heat generated from the winding may be efficiently dispersed through spaces between the winding and the winding frame and through the slots. Air may be introduced into the slots through the fan, and heat may be discharged through inlet and outlet grooves (inlet and outlet portions) and the slots, thereby stabilizing temperature. Through air cooling heat dissipation, heat generated from the winding may be efficiently dispersed, improving stability.

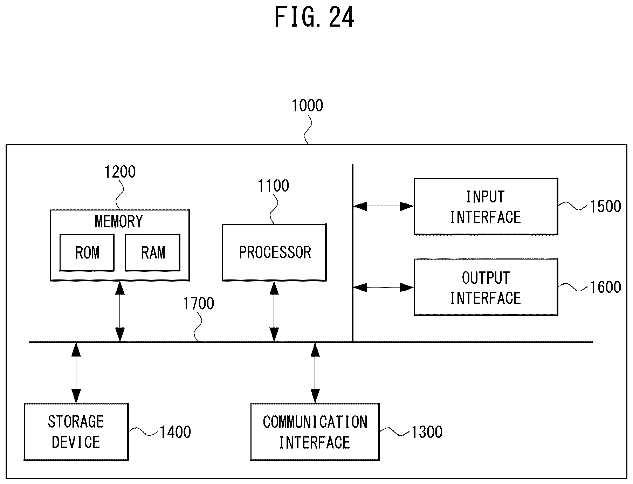

FIG. 24 is a block diagram illustrating a generalized configuration of hardware that is included in or associated with a wireless power transmission pad and/or a wireless power reception pad of the present disclosure to control a sequence for wireless power transfer.

For convenience of description, the hardware controlling the sequence for the wireless power transfer may be referred to as a controller 1000.

At least part of a process of a wireless charging method for controlling a sequence for wireless power transfer through a wireless charging system according to an exemplary embodiment of the present disclosure, and a heat dissipation method for controlling a driving of a fan during wireless charging and a heat dissipation sequence of coils included in the wireless charging system, may be executed by a controller 1000 of FIG. 24.

The controller 1000 may be disposed on a side of the electric vehicle 100, on a side of the electric vehicle supply equipment (EVSE), or on a side of the power transmission device or pad 210.

The controller 1000 may include at least one processor 1100, a memory 1200 storing at least one instruction for performing the operations described above through the processor 1100, and a communication interface 1300 connected to a network to perform communications. The controller 1000 for wireless power transfer may further include a storage device 1400 capable of storing the at least one instruction for performing the operations described above or data generated during the execution of the instruction. The controller 1000 for wireless power transfer may further include an input interface 1500 and an output interface 1600 for interactions with a user. The components of the controller 1000 for wireless power transfer may be connected to each other by a system bus 1700 to communicate with each other.

The controller or computing system 1000 according to an embodiment of the present disclosure may include at least one processor 1100 and the memory 1200 storing program instructions instructing the at least one processor 1100 to perform at least one process step. At least some of the operations or process steps of the method according to an embodiment of the present disclosure may be performed by the at least one processor 1100 loading and executing the program instructions from the memory 1200.

The processor 1100 may include a central processing unit (CPU) or a graphics processing unit (GPU) or may be implemented by another kind of dedicated processor suitable for performing the method of the present disclosure.

Each of the memory 1200 and the storage device 1400 may be comprised of at least one of a volatile storage medium and a non-volatile storage medium. For example, the memory 1200 may be comprised of at least one of a read only memory (ROM) and a random access memory (RAM).

Here, the at least one instruction may include at least one of: a sequence suitable for identifying at least one of the electric vehicle 10, the electric vehicle supply equipment (EVSE) 20, and the power transmission pad 21, a sequence suitable for associating two or more devices among the electric vehicle 10, the electric vehicle supply equipment (EVSE) 20, the power transmission pad 21 through wireless communications, a sequence suitable for performing the alignment and/or the pairing through a positioning of a counterpart device, and a sequence suitable for allowing to supply an alternating current power for the power transfer after the alignment and/or the pairing.

Additionally, the controller 1000 may include the communication interface 1300 that performs communications through a wireless communication network.

Additionally, the controller 1000 may further include the storage device 1400, the input interface 1500, and the output interface 1600.

The components of the controller 1000 may be connected to each other by the system bus 1700 to communicate with each other.

The controller 1000 according to an exemplary embodiment of the present disclosure may be any data processing device capable of communications through a network such as a desktop computer, a laptop computer, a notebook PC, a smartphone, a tablet PC, a mobile phone, a smart watch, smart glasses, an e-book reader, a portable multimedia player (PMP), a portable game console, a navigation device, a digital camera, a digital multimedia broadcasting (DMB) player, a digital audio recorder, a digital audio player, a digital video recorder, a digital video player, and a personal digital assistant (PDA). The device and method according to exemplary embodiments of the present disclosure can be implemented by computer-readable program codes or instructions stored on a computer-readable intangible recording medium. The computer-readable recording medium includes all types of recording device storing data which can be read by a computer system. The computer-readable recording medium may be distributed over computer systems connected through a network so that the computer-readable program or codes may be stored and executed in a distributed manner.

The computer-readable recording medium may include a hardware device specially configured to store and execute program instructions, such as a ROM, RAM, and flash memory. The program instructions may include not only machine language codes generated by a compiler, but also high-level language codes executable by a computer using an interpreter or the like.

Some aspects of the present disclosure described above in the context of the device may indicate corresponding descriptions of the method according to the present disclosure, and the blocks or devices may correspond to operations of the method or features of the operations. Similarly, some aspects described in the context of the method may be expressed by features of blocks, items, or devices corresponding thereto. Some or all of the operations of the method may be performed by (or using) a hardware device such as a microprocessor, a programmable computer, or electronic circuits, for example. In some exemplary embodiments, one or more of the most important operations of the method may be performed by such a device.

In some exemplary embodiments, a programmable logic device such as a field-programmable gate array may be used to perform some or all of functions of the methods described herein. In some exemplary embodiments, the field-programmable gate array may be operated with a microprocessor to perform one of the methods described herein. In general, the methods are preferably performed by a certain hardware device.

The description of the disclosure may be merely exemplary in nature and, thus, variations that do not depart from the substance of the disclosure may be intended to be within the scope of the disclosure. Such variations may not be to be regarded as a departure from the spirit and scope of the disclosure. Thus, it will be understood by those of ordinary skill in the art that various changes in form and details may be made without departing from the spirit and scope as defined by the following claims.

## Claims

1. A wireless charging pad applied as one or more of a reception pad on an electric mobility side or a transmission pad on an electric vehicle supply equipment (EVSE) side to wirelessly transfer electric power from an electric vehicle supply equipment to an electric mobility, comprising:
a winding frame; and
a coil disposed in the winding frame to surround a central space,
wherein the winding frame has a flow groove formed therein so that air introduced from a first side surface of the winding frame is discharged toward a second side surface of the winding frame.

2. The wireless charging pad of claim 1, wherein the winding frame has an air flow path formed therein so that air introduced from the first side surface is discharged toward an inlet and outlet portion of the coil.

3. The wireless charging pad of claim 1, wherein the flow groove is formed under the coil.

4. The wireless charging pad of claim 1, wherein a plurality of guides are formed on the winding frame to guide a winding position of the coil.

5. The wireless charging pad of claim 2 or claim 4, wherein air introduced from the first side surface via a fan passes through a passage formed by segments of the coil wound along the guides and is discharged toward the second side surface or the inlet and outlet portion.

6. The wireless charging pad of claim 4, wherein a point of a first guide of the plurality of guides contacts a point of a first segment of the wound coil, and another point of the first guide of the plurality of guides contacts a point of a second segment of the wound coil.

7. The wireless charging pad of claim 1, further comprising:
a ferrite core disposed above the coil; and
an aluminum plate disposed above the ferrite core.

8. The wireless charging pad of claim 7, wherein a part of the coil and a part of the ferrite core are exposed to the outside by the flow groove.

9. The wireless charging pad of claim 7, further comprising:
a first insulating pad disposed between the coil and the ferrite core; and
a second insulating pad disposed between the ferrite core and the aluminum plate.

10. A wireless charging system for wirelessly transferring electric power from an electric vehicle supply equipment (EVSE) to an electric mobility, comprising:
a transmission pad on an electric vehicle supply equipment side; and
a reception pad on an electric mobility side for receiving wireless power from the transmission pad,
wherein each of the transmission pad and the reception pad includes a winding frame and a coil disposed in the winding frame to surround a central space, and
the winding frame has a flow groove formed therein so that air introduced from a first side surface of the winding frame is discharged toward a second side surface of the winding frame.

11. The wireless charging system of claim 10, wherein an air flow path is formed so that air introduced from the first side surface is discharged toward an inlet and outlet portion of the coil.

12. The wireless charging system of claim 10, wherein the flow groove is formed under the coil.

13. The wireless charging system of claim 10, wherein a plurality of guides are formed on the winding frame to guide a winding position of the coil.

14. The wireless charging system of claim 11 or claim 13, wherein air introduced from the first side surface via a fan passes through a passage formed by segments of the coil wound along the guides and is discharged toward the second side surface or the inlet and outlet portion.

15. The wireless charging system of claim 13, wherein a point of a first guide of the plurality of guides contacts a point of a first segment of the wound coil, and another point of the first guide of the plurality of guides contacts a point of a second segment of the wound coil.

16. The wireless charging system of claim 10, further comprising:
a ferrite core disposed above the wound coil; and
an aluminum plate disposed above the ferrite core.

17. The wireless charging system of claim 16, wherein a part of the coil and a part of the ferrite core are exposed to the outside by the flow groove.

18. The wireless charging system of claim 16, further comprising:
a first insulating pad disposed between the coil and the ferrite core; and
a second insulating pad disposed between the ferrite core and the aluminum plate.

19. The wireless charging system of claim 10, wherein based on the transmission pad and the reception pad being arranged in parallel, air introduced into the transmission pad and air introduced into the reception pad are introduced from the same direction.
